# EUROPEAN PATENT APPLICATION

(11) **EP 1 564 817 A1**
(43) Date of publication of application: **17.08.2005**
(21) Application number: 05250817.3
(22) Date of filing: 10.02.2005
(51) Int. Cl.: H01L 31/101, H01L 31/0232

(54) **Photodiode having light-absorption part separated by PN junction and method of fabricating the same**

(30) Priority: 10.02.2004 KR 2004008845
(71) Applicant: Samsung Electronics Co., Ltd., Suwon-si, Gyeonggi-do 442-742 (KR)
(72) Inventor: Kim, Tae-jin, Yeongtong-gu Suwon-si Gyeonggi-do (KR); Park, Jin-Hyeong, Yeongdeungpo-gu Seoul (KR)
(74) Representative: Mounteney, Simon James

(57) **Abstract**

A photodiode includes, a reflecting member that reflects light incident to a separating region toward light-absorption parts. A plurality of light-absorption parts are separated by the separating region, and the reflecting member formed on the separating region has at least one sloped surface capable of reflecting the light incident to the separating region in a concentrated manner toward the light-absorption parts. A method of fabrication of the photodiode is also disclosed.

## Description

### 1. Field of the Invention

The present invention relates to a photodiode and a method of fabricating the same, and more particularly to a photodiode having a light-absorption part that is separated by a PN junction, and a method of fabricating the same.

### 2. Description of the Related Art

Photodiodes are light-absorption devices that convert optical signals into electrical signals, which are widely available for optical pick-up devices such as CD-ROMs and DVDs or optical telecommunication.

On the other hand, when light is incident to a light-absorption part, electron-hole pairs are generated in a depletion region. The electron-hole pairs migrate through an externally connected transistor or interconnect line, thereby generating a current. That is, the current of the photodiode is intrinsically varied in accordance with an optical generating rate of carriers. This characteristic provides a useful method that converts temporally varying optical signals into electrical signals. Whereas, if light is incident to a junction separating region, almost no current is generated due to a lack of a depletion region.

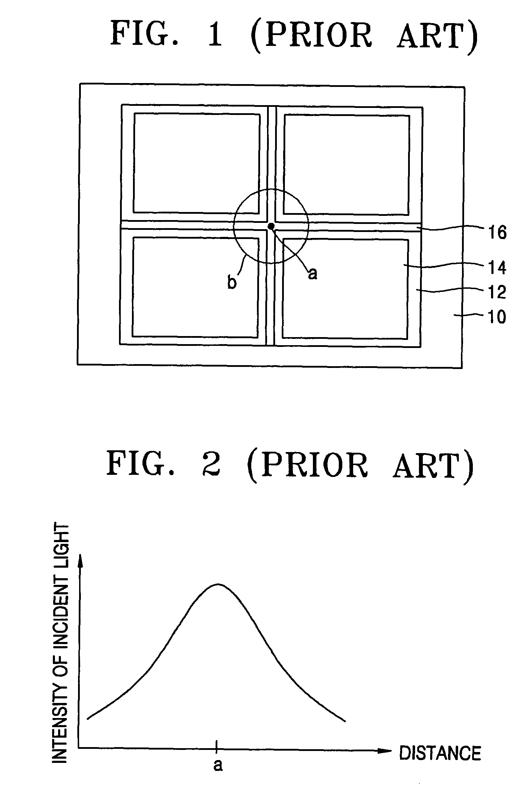

FIG. 1 is a plan view illustrating a conventional photodiode. FIG. 2 shows a graph that plots light intensity of light incident to the photodiode as a function of position.

Referring to FIG. 1, a photodiode region is defined by a device isolating layer formed on an upper portion of a semiconductor substrate (not shown), e.g., a P-type silicon substrate. An N-type epitaxial layer 12 within the photodiode region includes four light-absorption parts 14. The light-absorption parts 14 generate photoelectric charge from the light incident to a region highly doped with an impurity, e.g., an N-type impurity. The light absorption parts 14 are electrically insulated by means of a PN isolating region 16 using a PN junction.

The intensity of incident light has a distribution that tracks a Gaussian curve as shown in FIG. 2. That is, the incident light is concentrated on circled region b with a constant radius, centering about a point a at which the junction separating regions 16 cross. The junction separating region 16 in the surrounding region of area b scarcely converts optical signals into electrical signals. Thus, the incident light is not readily converted into electrical signals in this region, thereby degrading the efficiency of converting the incident light into an electrical signal.

### SUMMARY OF THE INVENTION

The present invention provides a photodiode having a light-absorption part that is separated by a PN junction, which enhances an efficiency of converting light incident to a junction separating region into an electrical signal by reflecting the incident light into the light-absorption part.

The present invention also provides a method of fabricating a photodiode having a light-absorption part separated by a PN junction, which enhances efficiency of the conversion of light incident to a junction separating region into an electrical signal by reflecting the incident light into the light-absorption part.

According to an aspect of the present invention, there is provided a photodiode having a light-absorption part separated by a PN junction including a plurality of light-absorption parts separated by a separating region. A reflecting member is formed on the separating region, which has at least one sloped surface capable of reflecting light incident to the separating region in a concentrated manner toward the light-absorption parts.

In one embodiment, the separating region is separated by the PN junction, and is preferably separated from the light-absorption part by a predetermined distance.

Here, the reflecting member can be formed of an insulating layer. Preferably, a bottom of the reflecting member covers an upper surface of the separating region, and a slope angle of the sloped surface of the reflecting member is 60 to 80° relative to an upper plane of the light absorption parts.

In another embodiment, the reflecting member has lateral sides that are symmetrical to each other. The reflecting member can have first and second legs that perpendicularly intersect, and optionally, first and second legs that are inwardly tapered toward each other at a point of intersection.

According to another aspect of the present invention, there is provided a method of fabricating a photodiode having a light-absorption part separated by a PN junction, in which a P-type epitaxial layer and an N-type epitaxial layer are sequentially stacked on a semiconductor substrate. Then, a junction separating region is formed on the N-type epitaxial layer, thereby electrically insulating neighboring light-absorption parts. A highly-doped N+ type light-absorption part is formed in an upper portion of the N-type epitaxial layer using ion implantation. Then, a reflecting member having at least one sloped surface is formed on the separating region for reflecting light incident to the junction separating region toward the light-absorption part.

In one embodiment, forming the junction separating region includes forming a first photoresist pattern that defines the junction separating region on the N-type epitaxial layer. Using the first photoresist pattern as an ion implantation mask, a P-type impurity is implanted into an upper portion of the N-type epitaxial layer and the P-type epitaxial layer.

Preferably, the light-absorption part is separated from the junction separating region by a predetermined distance.

Furthermore, forming the reflecting member can include forming a first interlayer insulating layer on the N-type epitaxial layer that includes the light-absorption part and the junction separating region. Then, a contact hole that exposes a conductive region is formed by etching the first interlayer insulating layer. A conductive material layer is deposited on the first interlayer insulating layer, thereby filling the contact hole. A second photoresist pattern that defines an interconnect line is formed on the conductive material layer. Thereafter, an interconnect line is formed by etching the conductive material layer using the second photoresist pattern as an etch mask. A second interlayer insulating layer is formed on the resultant structure, and a third photoresist pattern that defines the reflecting member is formed on the second interlayer insulating layer. Also, the reflecting member is formed by removing the second interlayer insulating layer and the first interlayer insulating layer by dry etching using the third photoresist pattern as an etch mask.

### BRIEF DESCRIPTION OF THE DRAWINGS

The above and other features and advantages of the present invention will become more apparent by describing in detail exemplary embodiments thereof with reference to the attached drawings in which:
FIG. 1 is a plan view illustrating a conventional photodiode;
FIG. 2 shows a graph plotting intensity of light incident to the photodiode;
FIGS. 3 through 9 are sectional views illustrating a photodiode having light-absorption parts according to the present invention; and
FIGS. 10 and 11 are perspective views illustrating specific exemplary shapes of a reflecting member according to the present invention.

### DETAILED DESCRIPTION OF PREFERRED EMBODIMENTS

The present invention will now be described more fully with reference to the accompanying drawings. The invention may, however, be embodied in many different forms and should not be construed as being limited to the embodiments set forth herein; rather these embodiments are provided so that this disclosure will be thorough and complete, and will fully convey the concept of the invention to those skilled in the art.

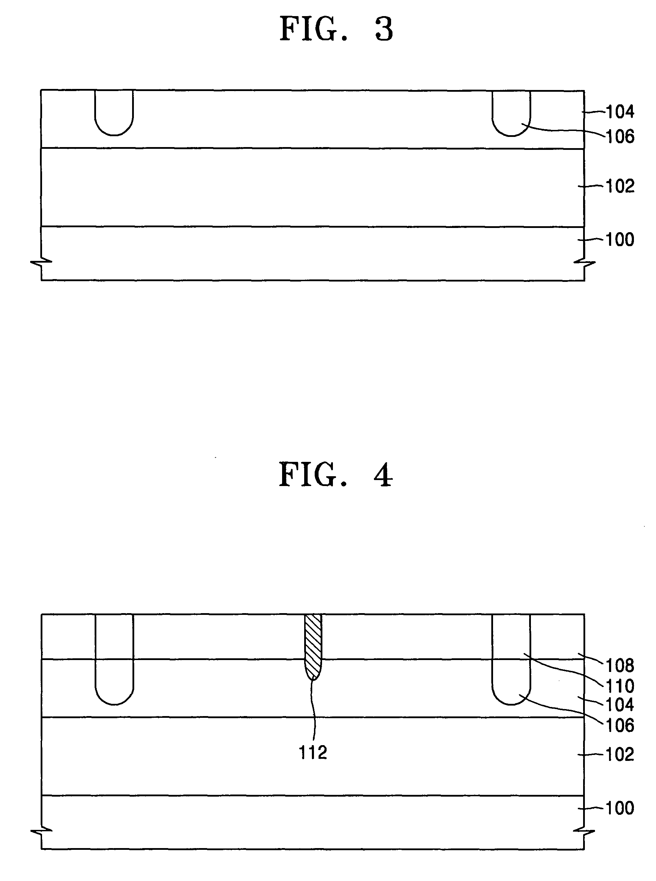

FIGS. 3 through 9 are sectional views illustrating a photodiode having a light-absorption part according to one embodiment of the present invention. Here, the photodiode described hereinafter has four light-absorption parts.

Referring to FIG. 3, a buried layer 102 is formed by ion implanting a highly-doped P-type impurity into an upper portion of a semiconductor substrate 100, e.g., P-type silicon substrate. The buried layer 102 functions to provide for decreased resistance against carrier migration, and is formed by implanting boron at a dose of 1x10¹⁵/cm² with an implanting energy of 40KeV. A P-type epitaxial layer 104 is formed via epitaxial growth on the buried layer 102. The thickness and sheet resistance of the P-type epitaxial layer 104 significantly affect energy conversion efficiency and signal processing speed of the resulting photodiode. Preferably, the thickness of the P-type epitaxial layer 104 is 8 to 12*µ*m and the sheet resistance thereof is 100 to 200Ω cm. Subsequently, a P-type impurity is implanted into an upper portion of the P-type epitaxial layer 104 via ion implantation, thereby forming a first conductive region 106 for a metal interconnect.

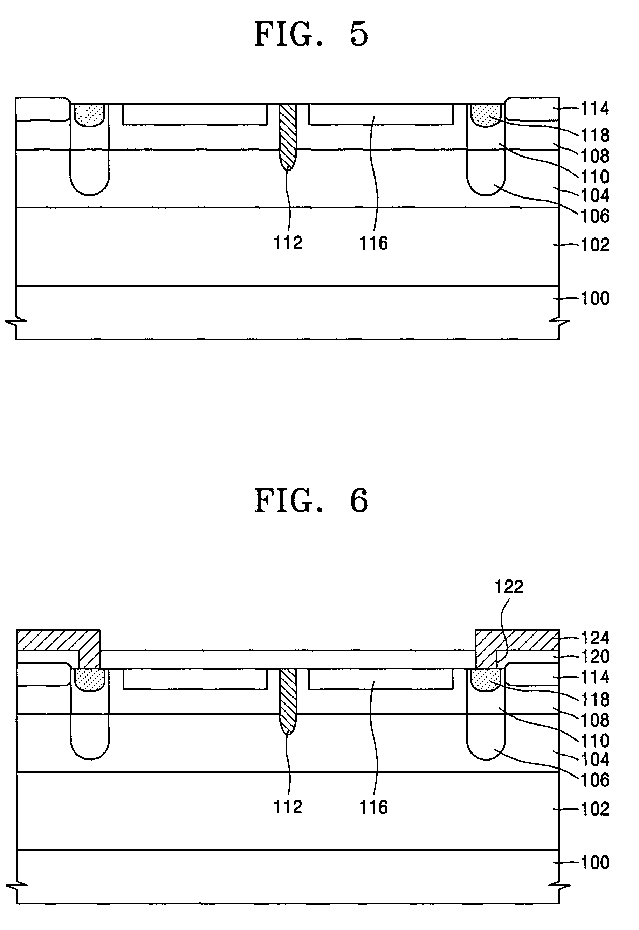

Referring to FIG. 4, an N-type epitaxial layer 108 is formed on the P-type epitaxial layer 104 that is formed with the first conductive region 106. The thickness and the sheet resistance of the N-type epitaxial layer 108 also significantly affect energy conversion efficiency and signal processing speed of the resulting photodiode, as do those of the P-type epitaxial layer 104. Preferably, the N-type epitaxial layer 108 has a thickness of 1 to 5µm and a sheet resistance of 20 to 50Ω cm. The double epitaxial layers 104 and 108 are formed in this embodiment for providing a bipolar transistor or a CMOS transistor in portions of the device other than the photodiode. Thereafter, a P-type impurity is implanted into the N-type epitaxial layer 108 on the first conductive region 106 via ion implantation, thereby forming a junction separating region 112 that electrically insulates between a second conductive region 110 for a metal interconnect and light-absorption part (116 of FIG.5) formed later. The second conductive region 110 and the junction separating region 112 are formed by implanting boron three times, a first time at a dose of 5x10¹³/cm² with an implanting energy of 10MeV~20MeV, a second time at a dose of 5x10¹³/cm² with an implanting energy of 1MeV~500KeV, and a third time at a dose of 5x10¹³/cm² with an implanting energy of 200eV~100eV in accordance with the thickness of the N-type epitaxial layer 108. Then, the resultant structure is annealed at a temperature of about 1000°C for 1 to 2 hours.

Referring to FIG. 5, a device isolating layer 114 that defines a region including the second conductive region 110, the junction separating region 112 and the light-absorption part 116 is formed in the N-type epitaxial layer 108. The device isolating layer 114 may be formed via Shallow Trench Isolation (STI) or LOCOS. If needed, a channel stop layer (not shown) is formed by ion implantation into a lower portion of the device isolating layer 114.

Thereafter, a light-absorption part 116 is formed by highly doping an N-type impurity into an upper portion of the N-type epitaxial layer 108 defined by the junction separating region 112. The light-absorption part 116 is formed by implanting antimony at a dose of 4x10¹⁵/cm² with an implanting energy of 50Kev, which is then annealed at a temperature of about 900°C for approximately 30 minutes. Preferably, the light-absorption part 116 is separated from the junction separating region 112 by a predetermined distance. Since the electron-hole pairs are generated at the N-type epitaxial layer 108 between the light-absorption part 116 and the junction separating region 112, the efficiency of conversion into electrical signals is enhanced. A third conductive region 118 for a metal interconnect is formed by implanting a P-type impurity into an upper portion of the second conductive region 110 via ion implantation. The third conductive region 118 is formed by implanting boron at a dose of 4x10¹⁵/cm² with an implanting energy of 50KeV, which is then annealed at a temperature of about 900°C for 30 minutes or so.

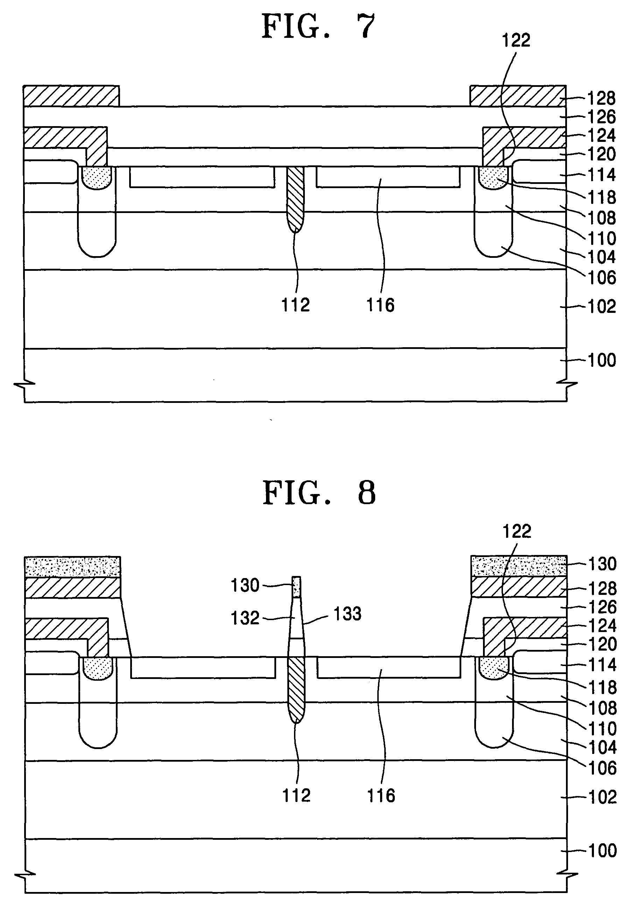

As shown in FIG. 6, a first interlayer insulating layer 120 is deposited on the entire surface of the semiconductor substrate 100 that includes the light-absorption part 116 and the junction separating region 112. Because the thickness of the first interlayer insulating layer 120 determines a height of a later-formed reflecting member (132 of FIG. 8), it may be determined by considering the height of the reflecting member. By etching the first interlayer insulating layer 120, a contact hole 122 that exposes the third conductive region 118 is formed. A conductive material layer is deposited on the first interlayer insulating layer 120, thereby filling the contact hole 122. A second photoresist pattern (not shown) that defines an interconnect line 124 is coated over the conductive material layer. The conductive material layer is etched using the photoresist pattern as an etch mask so as to form the interconnect line 124.

Referring to FIG. 7, a second interlayer insulating layer 126 is deposited on the first interlayer insulating layer 120 that is formed with the interconnect line 124 thereon. Because a thickness of the second interlayer insulating layer 126 determines the height of the reflecting member (132 of FIG. 8), it may be determined by considering the desired height of the reflecting member. Then, an upper surface of the second interlayer insulating layer 126 is planarized. A blocking metal layer 128 is formed on a planarized upper surface of the second interlayer insulating layer 126 via photolithography. The blocking metal layer 128 prevents light energy from entering regions of the device other than the light absorbing region.

Referring to FIG. 8, a third photoresist pattern 130 that defines a reflecting member 132 is coated over the second interlayer insulating layer 126. Using the third photoresist pattern 130 as an etch mask, the second interlayer insulating layer 126 and the first interlayer insulating layer 120 are removed by dry etching, thereby forming the reflecting member 132. The reflecting member 132 may be formed by a timed dry etch process under an Ar gas ambient using CF₄, CHF₃, C₂F₆, C₃F₈, C₄F₈, CH₂F₂, CH₃F, C₄F₆ or mixture of these and O₂ gas, for example.

At this time, a bottom surface of the reflecting member 132 preferably covers the upper surface of the junction separating region 112 for the purpose of preventing light from being incident thereon. Preferably, a slope angle at a bottom portion of the reflecting member formed by the bottom side and a lateral side of the reflecting member 132 is 60 to 80° . In other words, the reflecting member 132 has at least one sloped surface 133 that reflects incident light to the light-absorption part 116 in a concentrated manner. Furthermore, the lateral side of the reflecting member 132 may be symmetrically formed. In one example, the width of the bottom of the reflecting member is 1 to 3*µ*m and a height thereof is 1 to 2*µ*m. On the other hand, the length and the slope angle of the bottom side may be varied as needed. As mentioned above, the combined thicknesses of the first interlayer insulating layer 120 and the second interlayer insulating layer 126 are equal to the height of the reflective portion of the resulting reflecting member 132, which may be determined depending on device application.

According to the embodiment of the present invention, the reflecting member 132 has the advantage of being formed by merely changing the mask that is used to form the device, without significantly changing the process.

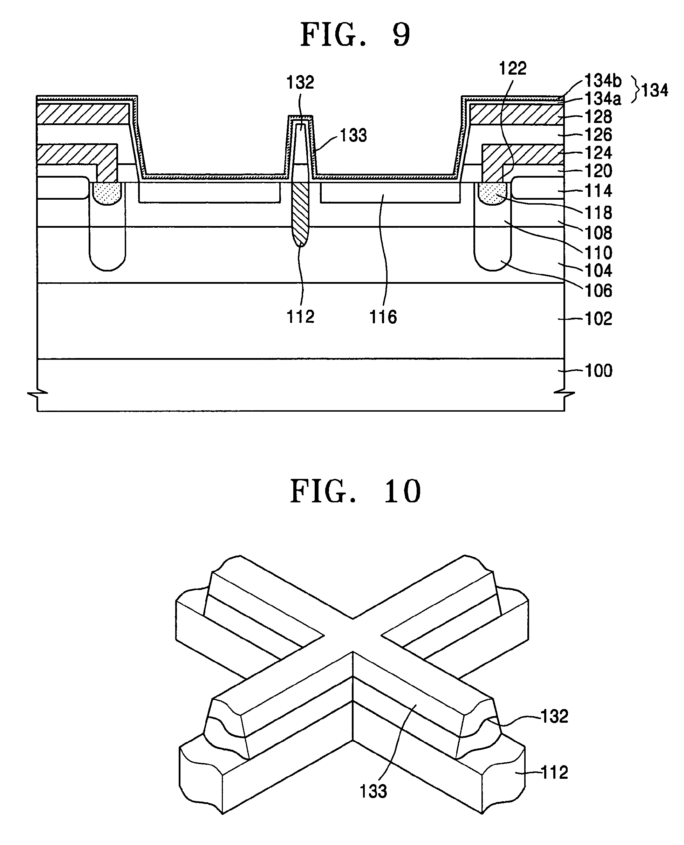

Referring to FIG. 9, an oxide layer 134a, a nitride layer 134b or an anti-reflecting layer 134 formed by stacking the two layers are deposited on the entire surface of the semiconductor substrate 100 formed with the reflecting member 132 thereon. The anti-reflecting layer 134 absorbs energy of the incident light to produce heat so as to guide the incident light along its path. Here, the oxide layer may be formed of a SiO layer, a SiO₂ layer, an Al₂O₃ layer and a HfO₂ layer. The nitride layer may comprise a silicon nitride layer. The stacked layer of the oxide layer/nitride layer enhances the effect of preventing reflection. The constituting material and thickness of the anti-reflecting layer 134 may be appropriately selected in accordance with light wavelength and the quantity of the light incident to the light-absorption part. At this time, the oxide layer and the nitride layer may be formed via vacuum deposition or CVD, and more preferably via plasma-enhanced chemical vapour deposition (PECVD) that uses plasma.

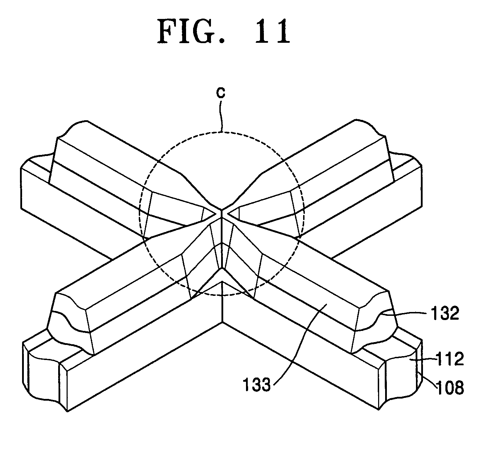

FIGS. 10 and 11 are perspective views illustrating specific exemplary shapes of the reflecting member 132 according to the embodiment of the present invention.

Referring to FIG. 10, the reflecting member 132 has a perpendicularly crossing shape, which is disposed on the junction separating region 112. The member 132 includes first and second legs that intersect over the junction separating region. The reflecting member 132 has at least one inwardly sloped surface 133, for example comprising a plane, on a side wall thereof. Respective widths of the upper plane and the bottom plane are almost constant. Preferably, the lateral sides of the reflecting member 132 are symmetrically formed. By doing so, when light is incident to the reflecting member 132, it is reflected at a predetermined angle and redirected toward the light-absorption parts 116.

Referring to FIG. 11, in this embodiment, the reflecting member 132 is formed by tapering the widths of the upper plane and the bottom plane at the same level toward the intersection point. The tapered region c corresponds to the area (b of FIG. 1) where the light intensity is strongest. At the portion c, the junction separating area 112 is covered but the N-type epitaxial layer 108 is exposed. That is, by exposing the N-type epitaxial layer 108, a depletion region of the photodiode is further secured.

According to a photodiode having a light-absorption part separated by a PN junction and a method of fabricating the same, light incident at the junction separating region is reflected to light-absorption parts by means of a reflecting member that has at least one sloped plane. Thus, efficiency of the conversion of optical signals into electrical signals is enhanced.

Also, according to the present invention, only the mask need be changed to accomplish the energy conversion enhancement, without changing the overall fabrication process. Therefore, the present invention is readily applicable to common processes for fabricating the photodiode.

While the present invention has been particularly shown and described with reference to exemplary embodiments thereof, it will be understood by those of ordinary skill in the art that various changes in form and detail may be made herein without departing from the spirit and scope of the present invention as defined by the following claims. For example, the preferred embodiment of the present invention is defined to the photodiode having four light-absorption parts, but will be applied to another photodiode having a plurality of light-absorption part.

## Claims

1. A photodiode having a light-absorption part separated by a PN junction comprising:
a plurality of light-absorption parts separated by a separating region; and
a reflecting member formed on the separating region and having at least one sloped surface capable of reflecting light incident to the separating region toward the light-absorption parts.

2. The photodiode having a light-absorption part separated by a PN junction of claim 1, wherein the separating region is separated by the PN junction.

3. The photodiode having a light-absorption part separated by a PN junction of claim 1, wherein the separating region and the light-absorption part are separated from each other by a predetermined distance.

4. The photodiode having a light-absorption part separated by a PN junction of claim 1, wherein the reflecting member is formed of an insulating layer.

5. The photodiode having a light-absorption part separated by a PN junction of claim 1, wherein a bottom of the reflecting member covers an upper surface of the separating region.

6. The photodiode having a light-absorption part separated by a PN junction of claim 1, wherein a slope angle of the sloped surface of the reflecting member is 60 to 80° relative to an upper plane of the light absorption parts.

7. The photodiode having a light-absorption part separated by a PN junction of claim 1, wherein the reflecting member has lateral sides that are symmetrical to each other.

8. The photodiode having a light-absorption part separated by a PN junction of claim 1, wherein the reflecting member has first and second legs perpendicularly intersect.

9. The photodiode having a light-absorption part separated by a PN junction of claim 1, wherein the reflecting member has first and second legs with side walls that are inwardly tapered toward each other at a point of intersection.

10. A method of fabricating a photodiode having a light-absorption part separated by a PN junction comprising:
sequentially stacking a P-type epitaxial layer and an N-type epitaxial layer on a semiconductor substrate;
forming a junction separating region on the N-type epitaxial layer for electrically insulating neighboring light-absorption parts;
forming a highly-doped N+ type light-absorption part in an upper portion of the N-type epitaxial layer using ion implantation; and
forming a reflecting member on the separating region having at least one sloped surface that reflects light incident to the junction separating region toward the light-absorption part.

11. The method of fabricating a photodiode having a light-absorption part separated by a PN junction of claim 10, wherein the forming the junction separating region comprises:
forming a first photoresist pattern that defines the junction separating region on the N+ type epitaxial layer; and
implanting a P-type impurity into an upper portion of the N-type epitaxial layer and the P-type epitaxial layer using the first photoresist pattern as an ion implantation mask.

12. The method of fabricating a photodiode having a light-absorption part separated by a PN junction of claim 10, wherein the light-absorption part is separated from the junction separating region by a predetermined distance.

13. The method of fabricating a photodiode having a light-absorption part separated by a PN junction of claims 10 and 11, wherein the forming the reflecting member comprises:
forming a first interlayer insulating layer on the N-type epitaxial layer that includes the light-absorption part and the junction separating region;
forming a contact hole that exposes a conductive region by etching the first interlayer insulating layer;
filling the contact hole by depositing a conductive material layer on the first interlayer insulating layer;
forming a second photoresist pattern that defines an interconnect line on the conductive material layer;
forming an interconnect line by etching the conductive material layer using the second photoresist pattern as an etch mask;
forming a second interlayer insulating layer on the resultant structure;
forming a third photoresist pattern that defines the reflecting member on the second interlayer insulating layer; and
forming the reflecting member by removing the second interlayer insulating layer and the first interlayer insulating layer by dry etching using the third photoresist pattern as an etch mask.

14. The method of fabricating a photodiode having a light-absorption part separated by a PN junction of claim 10, wherein a bottom of the reflecting member covers an upper surface of the junction separating region.

15. The method of fabricating a photodiode having a light-absorption part separated by a PN junction of claim 10, wherein a slope angle of the sloped surface of the reflecting member is 60 to 80° relative to an upper plane of the light absorption parts.
